# EUROPEAN PATENT APPLICATION

(11) **EP 4 701 356 A1**
(43) Date of publication of application: **25.02.2026**
(21) Application number: 23947284.8
(22) Date of filing: 16.10.2023
(51) Int. Cl.: H05K 5/03, H05K 5/02

(54) **MAIN CONTROL BOX, ENERGY STORAGE SYSTEM, AND ELECTRIC DEVICE**

(30) Priority: 31.07.2023 CN 202322029230 U
(71) Applicant: Contemporary Amperex Technology Co., Limited, Ningde, Fujian 352100 (CN)
(72) Inventor: TANG, Chunfeng, Ningde, Fujian 352100 (CN); LIANG, Yanhui, Ningde, Fujian 352100 (CN); WU, Xiehui, Ningde, Fujian 352100 (CN); HE, Shuangjiang, Ningde, Fujian 352100 (CN); YIN, Kaibo, Ningde, Fujian 352100 (CN); HU, Qiangwei, Ningde, Fujian 352100 (CN); WANG, Xiang, Ningde, Fujian 352100 (CN); TANG, Hongjia, Ningde, Fujian 352100 (CN); FAN, Yuanbin, Ningde, Fujian 352100 (CN)
(74) Representative: Ziebig Hengelhaupt Intellectual Property Attorneys Patentanwaltskanzlei PartGmbB
(86) International application number: PCT/CN2023/124719
(87) International publication number: WO 2025/025345

(57) **Abstract**

A main control box, an energy storage system, and an electric device. The main control box includes: a box body accommodating a control component of a battery; and a box cover disposed above the box body and covering the box body, wherein a lower surface of the box cover is provided with a water absorption layer for absorbing water vapor within the main control box. The control component includes a battery management unit, and the orthographic projection of the water absorption layer on the box cover covers the orthographic projection of the battery management unit on the box cover. The performance stability of the main control box can be improved.

## Description

The present application claims priority to the Utility Model Application No. 202322029230.8, filed with the China National Intellectual Property Administration on July 31, 2023 and entitled "MAIN CONTROL BOX, ENERGY STORAGE SYSTEM, AND ELECTRIC DEVICE", the entire disclosure of which is incorporated herein by application.

### TECHNICAL FIELD

Embodiments of the present application relate to the technical field of batteries, and in particular, to a main control box, an energy storage system, and an electric device.

### BACKGROUND

For a traditional main control box, water vapor condensation inside of a box body is not considered, and only external sealing control is carried out, which can easily result in generation of condensed water. When the condensed water drops onto core parts inside of the box body, performance stability of the main control box may be affected.

### SUMMARY

Given that, the embodiments of the present application provide a main control box, an energy storage system, and an electric device, and performance stability of the main control box can be improved.

In a first aspect, provided is a main control box, comprising: a box body accommodating a control component of a battery; and a box cover disposed above the box body and covering the box body, wherein a lower surface of the box cover is provided with a water absorption layer for absorbing water vapor within the main control box. The control component comprises a battery management unit, and the orthographic projection of the water absorption layer on the box cover covers the orthographic projection of the battery management unit on the box cover.

In this embodiment, by setting the orthographic projection of the water absorption layer on the box cover to cover the orthographic projection of the battery management unit on the box cover, at least the probability that condensed water is generated above the battery management unit can be reduced, so that the possibility that the condensed water drops onto the battery management unit can be further reduced, thereby improving the performance stability of the main control box. In addition, the water absorption layer may be disposed only above the battery management unit, which can reduce cost for the main control box.

In a possible implementation, the main control box further comprises a drainage structure for draining condensed water generated above the battery management unit out of the battery management unit.

In this embodiment, even if water absorption effect of the water absorption layer is not good enough, which still results in generation of condensed water, the condensed water generated above the battery management unit may not drop onto the battery management unit by disposing the drainage structure within the main control box, thereby enabling further improvement in the performance stability of the main control box.

In a possible implementation, the drainage structure comprises a drainage plate disposed below the water absorption layer and covering at least a part of the water absorption layer. An opening is formed between a first end of the drainage plate in a first direction and the box cover, and a second end of the drainage plate in the first direction is fixedly connected to the box cover, wherein the orthographic projection of the first end on the box cover is staggered with the orthographic projection of the battery management unit on the box cover, and the first direction is perpendicular to a gravity direction of the main control box.

In this embodiment, by staggering the orthographic projection of the first end of the drainage plate on the box cover with the orthographic projection on the battery management unit, the opening and the battery management unit are disposed in a staggered mode in the first direction, so that the condensed water dropping from the opening can avoid the battery management unit, thereby enabling further improvement in the performance stability of the main control box.

In a possible implementation, the orthographic projection of the second end on the box cover is staggered with the orthographic projection of the battery management unit on the box cover.

In this embodiment, by staggering the orthographic projection of the second end on the box cover with the orthographic projection of the battery management unit on the box cover, it is facilitated that the condensed water generated above the battery management unit can be diverted away from the battery management unit, thereby enabling further improvement in the performance stability of the main control box.

In a possible implementation, the box body comprises a first side wall, the first side wall is a wall of the box body closer to the opening in the first direction, and a gap is provided between the opening and the first side wall; and the drainage structure further comprises a drainage groove disposed within the gap and being in communication with the opening.

In this embodiment, the drainage groove is disposed within the gap and communicates with the opening, so that the condensed water dropping from the opening can drop along the drainage groove into the gap between the battery management unit and the first side wall, thereby reducing the possibility that the condensed water drops onto the battery management unit, and further improving the performance stability of the main control box.

In a possible implementation, the material of the water absorption layer comprises a polyurethane waterproof coating.

In this embodiment, the polyurethane waterproof coating is used as the water absorption layer, and the polyurethane material has a low thermal conductivity since it has a stable porosity structure, predominantly a closed-pore structure. When the polyurethane material is sprayed on the box cover, heat conduction is slower when an external temperature is relatively low and an internal temperature is relatively high, the internal temperature decreases slowly, and condensation is not easily formed. When very little condensation occurs internally, the polyurethane material can also react with water to absorb it, thereby effectively reducing the probability of condensed water generation.

In a possible implementation, the material of the water absorption layer comprises a flocking material.

In this embodiment, the flocking material is used as the water absorption layer, which can greatly absorb water vapor within the main control box, so that the probability of condensed water generation can be effectively reduced.

In a possible implementation, the thickness of the absorption layer is greater than or equal to 2 mm.

In this embodiment, if the thickness of the water absorption layer is set to be less than 2 mm, moisture-proof requirement for the main control box may not be met, and by setting the thickness H of the water absorption layer to be greater than or equal to 2 mm, the probability of condensed water generation can be reduced to the greatest extent.

In a possible implementation, the thickness of the water absorption layer is less than or equal to 5 mm.

In this embodiment, if the thickness of the water absorption layer is set to be greater than 5 mm, the water absorption layer may easily fall off and the moisture-proof requirement for the main control box still cannot be met, and by setting the thickness of the water absorption layer to be greater than or equal to 5 mm, the probability of condensed water generation can be reduced to the greatest extent.

A second aspect provides an energy storage system comprising a battery and the main control box according to the first aspect and any of its possible implementations.

A third aspect provides an electric device comprising a battery and the main control box according to the first aspect and any of its possible implementations.

### DESCRIPTION OF DRAWINGS

FIG. 1 is a schematic block diagram of an energy storage system according to an embodiment of the present application;
FIG. 2 shows a first schematic cross-sectional view of a main control box according to an embodiment of the present application.
FIG. 3 shows a second schematic cross-sectional view of a main control box according to an embodiment of the present application.
FIG. 4 shows a third schematic cross-sectional view of a main control box according to an embodiment of the present application.
FIG. 5 shows a schematic top view of a box cover of a main control box according to an embodiment of the present application.

Description of reference signs: 100 - Energy storage system; 110 - Battery; 120 - Main control box; 121-SBMU; 130 - Box body; 140 - Box cover; 150 - Water absorption layer; 160 - Control component; H - Thickness of water absorption layer; 161 - Battery management unit; 170 - Drainage structure; 171 - Drainage plate; 172 - Drainage groove; 180 - Opening; L - Gap; 131 - First side wall; 1711 - First end; 1712 - Second end.

### DESCRIPTION OF EMBODIMENTS

The following further describes implementations of the present application in detail with reference to the accompanying drawings and embodiments. The following detailed description of the embodiments and the accompanying drawings are used to describe the principles of the present application by way of example, but are not intended to limit the scope of the present application, that is, the present application is not limited to the described embodiments.

In the description of the present application, it should be noted that, orientations or positional relationships indicated by the terms "upper", "lower", "left", "right", "inner", "outer", and the like are merely for convenience of description of the present application and simplicity of description, and do not indicate or imply that an apparatus or an element to be referred to must have a specific orientation, or be constructed and operated in a specific orientation, and therefore should not be understood as a limitation on the present application. In addition, the terms "first", "second", "third", and the like are used merely for description purposes, and should not be understood as an indication or implication of relative importance. "Perpendicular" is not perpendicular in the strict sense, but is within an allowable range of error. "Parallel" is not parallel in the strict sense, but is within an allowable range of error.

The orientation words appearing in the following description are all directions shown in the drawings, and do not limit the specific structure in the present application. In the descriptions of the present application, it should be further noted that, unless otherwise explicitly specified and defined, the terms "mounted", "connected", and "connect" are to be understood in a broad sense, for example, may be fixedly connected, detachably connected, or integrally connected, may be directly connected, or may be indirectly connected via an intermediate medium. Those of ordinary skill in the art may understand specific meanings of these terms in the present application according to specific situations.

The term "and/or" in the present application is only an associative relationship for describing associated objects, indicating that three relationships may be present. For example, A and/or B may indicate three cases: presence of only A; presence of both A and B; and presence of only B. In addition, the symbol "/" in the present application generally represents an "or" relationship between associated objects.

In the embodiments of the present application, the same reference numerals denote the same component, and a detailed description of the same component is omitted in different embodiments for the sake of brevity. It should be understood that the dimensions of various components, such as the thickness, length, and width, and the dimensions of an integrated device, such as the overall thickness, length, and width, in the embodiments of the present application shown in the figures are merely illustrative and should not be construed as limiting the present application.

In the present application, "plurality of" means more than two (inclusive). Similarly, "plurality of groups" means more than two (inclusive) groups, and "plurality of pieces" means more than two (inclusive) pieces.

The main control box is usually electrically connected to one or more batteries for controlling and managing the one or more batteries. For example, data such as voltages, currents, and temperatures of the batteries may be read during operation. For another example, the on/off states of the batteries may be controlled.

For a traditional main control box, water vapor condensation inside of a box body is not considered, and only external sealing control is made, which can easily result in generation of condensed water. When the condensed water drops to core parts inside of the box body, performance stability of the main control box may be affected.

Given that, an embodiment of the present application provides a main control box, and by providing a water absorption layer at a surface facing a box body of a box cover to absorb water vapor within the main control box, the probability of condensed water generation is reduced, so that the performance stability of the main control box can be improved.

It should be noted that the main control box provided in the embodiments of the present application may be applied to an energy storage system, or an electric device. For ease of description bellow, its application in the energy storage system is mainly described.

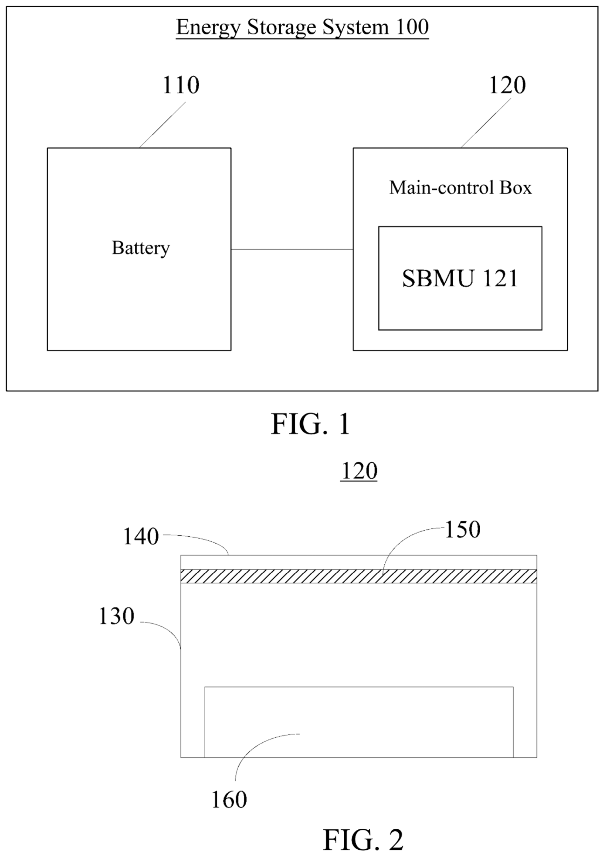

FIG. 1 shows a schematic block diagram of an energy storage system. As shown in FIG. 1, the energy storage system 100 may include a battery 110 and a main control box 120.

Generally, an energy storage system is a device storing energy and can accommodate one or more energy storage elements, wherein the energy storage element may be a battery. For example, as shown in FIG. 1, the energy storage system 100 includes one or more batteries 110, wherein one battery 110 may also be referred to as a battery box, which includes a box body and one or more battery cells encapsulated by the box body. The embodiments of the present application do not limit the types and shapes of the battery cells, for example, the battery cells may include metal batteries, lithium ion secondary batteries, lithium ion primary batteries, lithium sulfur batteries, sodium lithium ion batteries, sodium ion batteries, or magnesium ion batteries, and as another example, the battery cells may be in a shape of a cylinder, a flat body, a cuboid, or the like.

Optionally, as shown in FIG. 1, the energy storage system 100 may further include a main control box 120, which may be a box-body structure having a control component, and the control component may be a programmable logic controller. The main control box 120 may be used for being electrically connected to one or more batteries 110, and the main control box 120 may also be connected to a master control system. The main control box 120 may be used to control and manage one or more batteries 110. For example, the main control box 120 may read data such as voltages, currents, and temperatures of the batteries 110 during operation. For another example, the main control box 120 may control on/off states of the batteries 110.

Optionally, within the main control box 120, core parts such as a slave battery management unit (SBMU) 121 or the like may be disposed. The SBMU 121 can perform all-round monitoring and control on the batteries 110, to ensure safety, long service life, and performance stability of the batteries 110.

In other embodiments, various auxiliary parts such as a relay, a fuse protector, an indicator light, an isolation switch, a current sensor, a high-voltage copper bar, and a fuse may be further disposed within the main control box 120.

Optionally, other functional members may be further disposed in the energy storage system 100 to perform auxiliary operations on the plurality of energy storage elements. For example, the energy storage system 100 may be provided with a thermal management member, which includes, but is not limited to, an air conditioning assembly, a fan assembly, a water-cooling pipe, and the like, and may be used to perform thermal management on the battery 110 to adjust the internal temperature of the battery 110.

It should be understood that the energy storage system 100 in the embodiments of the present application may be applied to various scenarios such as home storage, outdoor energy storage, a power grid, or the like, which are not limited in the embodiments of the present application.

FIG. 2 shows a schematic cross-sectional view of a main control box according to an embodiment of the present application. As shown in FIG. 2, the main control box 120 includes a box body 130 and a box cover 140. Here, the box body 130 is a hollow structure having an opening. The box body 130 may accommodate a control component 160 of a battery. For example, the control component 160 may include the SBMU 121 as shown in FIG. 1. For another example, the control component 160 may further include various parts such as a relay, a fuse protector, an indicator light, an isolation switch, a current sensor, a high-voltage copper bar, a fuse, or the like.

In some examples, the box cover 140 may be disposed above the box body 130 to cover the box body 130. For example, the box cover 140 may cover the opening of the box body 130 to form a closed accommodating space. The control component 160 of the battery may be disposed inside of the accommodating space.

In some other examples, a water absorption layer 150 may be disposed at a lower surface of the box cover 140, and the water absorption layer 150 is used to absorb water vapor within the main control box 120.

Optionally, the water absorption layer 150 is usually made of some water absorption materials, for example, various polymer materials such as super absorbent resin, polyurethane, polyvinyl alcohol, polypropylene, or the like, and for another example, materials such as a flocking material, foam, nano silica, or the like.

In some embodiments, the water absorption layer 150 may be formed using the box cover 140 as a substrate by means of a process such as spraying or the like, or may be an independent water absorption layer 150 fixed to the lower surface of the box cover 140 by means of bonding or the like.

In this embodiment, by disposing the water absorption layer 150 at the lower surface of the box cover 140 to absorb the water vapor within the main control box 120, the probability of condensed water generation is reduced, so that the problem of poor performance stability of the main control box 120 due to the condensed water dropping onto the control component 160 within the box body 130 is improved. In addition, compared to a solution in which the main control box 120 is additionally equipped with a dehumidification apparatus, the water vapor within the main control box 120 can be absorbed without damaging the appearance of the main control box 120, thereby reducing energy consumption.

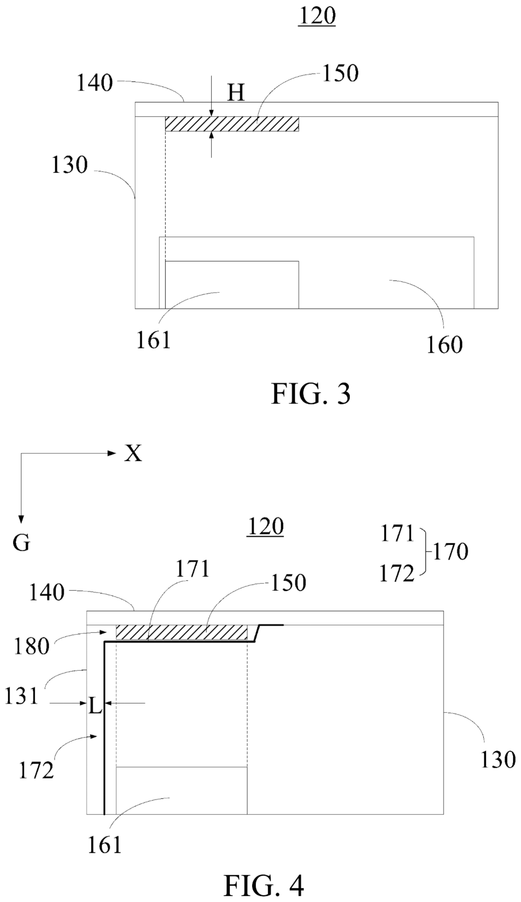

FIG. 3 shows another schematic cross-sectional view of a main control box according to an embodiment of the present application. As shown in FIG. 3, the control component 160 includes a battery management unit 161, and the orthographic projection of the water absorption layer 150 on the box cover 140 covers the orthographic projection of the battery management unit 161 on the box cover 140.

It should be explained that the orthographic projection of the water absorption layer 150 on the box cover 140 may refer to a projection of the water absorption layer 150 on the box cover 140 in the gravity direction G of the main control box 120; and the orthographic projection of the battery management unit 161 on the box cover 140 may refer to a projection of the water absorption layer 150 on the box cover 140 in the gravity direction G of the main control box 120.

In addition, the battery management unit 161 in the embodiments of the present application may be, for example, the SBMU 121 in FIG. 1, and related description may be referred to in the content above, which is not repeated here again for brevity.

The orthographic projection of the water absorption layer 150 on the box cover 140 covers the orthographic projection of the battery management unit 161 on the box cover 140, which may mean that the orthographic projection of the battery management unit 161 on the box cover 140 is located at the orthographic projection of the water absorption layer 150 on the box cover 140. For example, the water absorption layer 150 may be disposed only above the battery management unit 161. For another example, the water absorption layer 150 is not only disposed above the battery management unit 161, but also may be disposed above other control components.

It should be noted that the water absorption layer 150 being disposed above the battery management unit 161 may include the orthographic projection area of the water absorption layer 150 on the box body 130 completely overlapping with the orthographic projection area of the battery management unit 161 on the box body 130, or may include the orthographic projection area of the battery management unit 161 on the box body 130 being located within the orthographic projection area of the water absorption layer 150 on the box body 130, and the orthographic projection area of the water absorption layer 150 on the box body 130 being slightly larger than the orthographic projection area of the battery management unit 161 on the box body 130. For example, the boundary of the orthographic projection area of the water absorption layer 150 on the box body 130 may exceed, by 5 mm, the boundary of the orthographic projection area of the battery management unit 161 on the box body 130.

In this embodiment, by setting the orthographic projection of the water absorption layer 150 on the box cover 140 to cover the orthographic projection of the battery management unit 161 on the box cover 140, at least the probability that condensed water is generated above the battery management unit 161 can be reduced, and further, the possibility that the condensed water drops onto the battery management unit 161 can be reduced, thereby improving the performance stability of the main control box 120. In addition, the water absorption layer 150 may be disposed only above the battery management unit 161, which may reduce cost for the main control box 120.

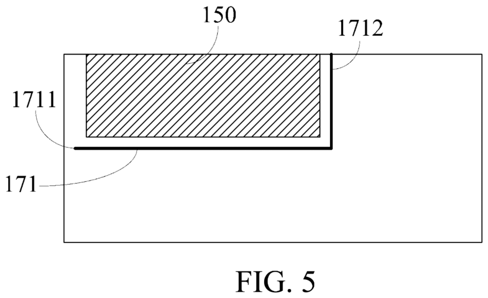

FIG. 4 shows still another schematic cross-sectional view of a main control box according to an embodiment of the present application. FIG. 5 shows a schematic top view of a box cover according to an embodiment of the present application. As shown in FIG. 4, the main control box 120 further includes a drainage structure 170, which is used to drain the condensed water generated above the battery management unit 161 out of the battery management unit 161.

In other words, the presence of the drainage structure 170 may cause the condensed water generated above the battery management unit 161 not to drop onto the battery management unit 161.

In this embodiment, even if the water absorption effect of the water absorption layer 150 is not good enough, still resulting in generation of condensed water, the condensed water generated above the battery management unit 161 may not drop onto the battery management unit 161 by disposing the drainage structure 170 within the main control box 120, thereby enabling further improvement in the performance stability of the main control box 120.

In some embodiments, as shown in FIG. 4, the drainage structure 170 includes a drainage plate 171 disposed below the water absorption layer 150, and covering at least a part of the water absorption layer 150. As shown in FIG. 4 and FIG. 5, an opening 180 is formed between a first end 1711 of the drainage plate 171 in a first direction X and the box cover 140, and a second end 1712 of the drainage plate 171 in the first direction X is fixedly connected to the box cover 140. Here, the orthographic projection of the first end 1711 on the box cover 140 is staggered with the orthographic projection on the battery management unit 161, and the first direction X is perpendicular to the gravity direction G of the main control box 120.

Optionally, a main structure of the drainage plate 171 in the embodiments of the present application is a plate-shaped structure, that is, a part of the drainage plate 171 covering a lower part of the water absorption layer 150 is a plate-shaped structure. In some embodiments, the drainage plate 171 may cover the entire water absorption layer 150. In some other embodiments, the drainage plate 171 may cover a part of the water absorption layer 150.

Optionally, as shown in FIG. 4, the first end 1711 of the drainage plate 171 in the first direction X is a free end, and the second end 1712 of the drainage plate 171 in the first direction X is a fixed end.

In some embodiments, as shown in FIG. 4, an opening 180 formed between the first end 1711 and the box cover 140 may face the first direction X. In some other embodiments, an opening may be formed between the first end 1711 and the side wall of the box body 130, and the opening may face the gravity direction G.

Optionally, the second end 1712 and the box cover 140 may be fixedly connected by means of bonding, riveting, threaded fasteners, or the like. For example, a lower surface of the box cover 140 may be provided with a fixing bolt, the second end 1712 is provided with a mounting hole, the fixing bolt is inserted into the mounting hole, and then the drainage plate 171 is mounted to the lower surface of the box cover 140 by means of cooperation between a nut and the bolt.

Similarly, the orthographic projection of the first end 1711 on the box cover 140 may refer to a projection of the first end 1711 on the box cover in the gravity direction G of the main control box 120. In the embodiments of the present application, the orthographic projection of the first end 1711 on the box cover 140 is staggered with the orthographic projection on the battery management unit 161, which may be understood as the opening 180 and the battery management unit 161 being disposed in a staggered manner in the first direction X.

It should be noted that the first direction X may be a longitudinal direction of the box cover 140 or a width direction of the box cover 140.

Due to gravity, the condensed water generated on the box cover 140 located above the battery management unit 161 would vertically drop onto the battery management unit 161, and in the embodiments of the present application, by staggering the orthographic projection of the first end 1711 of the drainage plate 171 on the box cover 140 with the orthographic projection on the battery management unit 161, the opening 180 and the battery management unit 161 are staggered in the first direction X, so that the condensed water dropping from the opening 180 can avoid the battery management unit 161, thereby enabling further improvement in the performance stability of the main control box 120.

Further referring to FIG. 4 and FIG. 5, the orthographic projection of the second end 1712 on the box cover 140 is staggered with the orthographic projection of the battery management unit 161 on the box cover 140.

For example, if the water absorption layer 150 is disposed only above the battery management unit 161, the drainage plate 171 may cover the entire water absorption layer 150 in the first direction X.

For another example, if the water absorption layer 150 is not only disposed above the battery management unit 161, but also disposed on other control components within the main control box 120, the drainage plate 171 may cover the entire water absorption layer 150, or only the water absorption layer 150 located above the battery management unit 161 in the first direction X.

In this embodiment, by staggering the orthographic projection of the second end 1712 on the box cover 140 with the orthographic projection of the battery management unit 161 on the box cover 140, it is facilitated that the condensed water generated above the battery management unit 161 can be diverted away from the battery management unit 161, thereby enabling further improvement in the performance stability of the main control box 120.

Optionally, as shown in FIG. 4, the box body 130 may include a first side wall 131, which is a wall of the box body 130 closer to the opening 180 in the first direction X, and a gap L is provided between the opening 180 and the first side wall 131, wherein the drainage structure 170 further includes a drainage groove 172 disposed within the gap L and communicating with the opening 180.

Generally, the battery management unit 161 is disposed at a position of the box body 130 close to the first side wall 131 of the box body 130 in the first direction X, that is, there is also a certain gap between the battery management unit 161 and the first side wall 131. As long as the condensed water drops within the gap, it does not drop onto the battery management unit 161.

In some embodiments, the first end 1711 of the drainage plate 171 may not be in contact with the first side wall 131, but has a certain distance from the first side wall 131, so that there is the gap L between the opening 180 and the first side wall 131, and optionally, the gap L between the opening 180 and the first side wall 131 should be smaller than the gap between the battery management unit 161 and the first side wall 131, thereby ensuring that the condensed water dropping from the opening 180 does not drop onto the battery management unit 161.

In this embodiment, the drainage groove 172 is disposed within the gap L, and is in communication with the opening 180, so that the condensed water dropping from the opening 180 can drop along the drainage groove 172 into the gap between the battery management unit 161 and the first side wall 131, thereby reducing the possibility that the condensed water drops onto the battery management unit 161, and further improving the performance stability of the main control box 120.

In some embodiments, the drainage groove 172 may be formed by disposing another drainage plate between the battery management unit 161 and the first side wall 131, the drainage groove 172 being formed between the other drainage plate and the first side wall 131. In some other embodiments, a separate member may be disposed between the first side wall 131 and the battery management unit 161, the member being provided with a through hole extending along the gravity direction G, and the through hole forming the drainage groove 172. It should be understood that the implementation of the drainage groove 172 is not limited in the embodiments of the present application.

Optionally, in the embodiments of the present application, the material of the drainage structure 170 may be an insulating material. For example, the material of the drainage structure is a PP material.

Optionally, in an embodiment, the material of the water absorption layer 150 includes a polyurethane waterproof coating.

The polyurethane waterproof coating is a single-component polyurethane waterproof coating prepared by procedures such as mixing, an isocyanate-containing prepolymer formed by processing and polymerization reaction of isocyanate, polyether, etc., with a catalyst, an anhydrous auxiliary agent, an anhydrous filler, a solvent, etc. Such a coating is a reaction-cured (moisturecured) coating, and has characteristics of high strength, large elongation, good water resistance, and the like. The coating is cured upon contact with moisture in air and a strong seamless integral waterproof membrane is formed on a surface of a base layer.

The foaming chemical formula of polyurethane with water is -NCO + H₂O → -NH₂ + CO₂↑.

Here, -NCO represents an isocyanate group, H₂O is a chemical formula of water, -NH₂ represents an amino group, and CO₂ is a chemical formula of carbon dioxide.

In this embodiment, the polyurethane waterproof coating is used as the water absorption layer 150, and the polyurethane material has a low thermal conductivity coefficient since it has a stable porosity structure, predominantly a closed-pore structure. When the polyurethane material is sprayed on the box cover 140, heat conduction is slower when an external temperature is relatively low and an internal temperature is relatively high, the internal temperature decreases slowly, and condensation is not easily formed. When very little condensation occurs internally, the polyurethane material can also react with water to absorb it, thereby effectively reducing the probability of condensed water generation.

Optionally, in another embodiment, the material of the water absorption layer 150 includes a flocking material. For example, the material of the water absorption layer 150 includes cotton flocking, polyester flocking, acrylic flocking, wool, acrylic, spandex, or the like.

In this embodiment, using the flocking material as the water absorption layer 150 can greatly absorb the water vapor within the main control box 120, so that the probability of condensed water generation can be effectively reduced.

In other embodiments, the material of the water absorption layer 150 may also include materials such as foam, nano silica, etc.

Optionally, as shown in FIG. 3, the thickness of the water absorption layer 150 is H, which may be greater than or equal to 2 mm.

In this embodiment, if the thickness of the water absorption layer 150 is set to be less than 2 mm, the moisture resistance requirement for the main control box 120 may not be met, and by setting the thickness H of the water absorption layer 150 to be greater than or equal to 2 mm, the probability of condensed water generation can be reduced to to the greatest extent.

Optionally, in the embodiments of the present application, H may be less than or equal to 5 mm.

In this embodiment, if the thickness of the water absorption layer 150 is set to be greater than 5 mm, the water absorption layer 150 may easily fall off, and the moisture-proof requirement for the main control box 120 still cannot be met, and by setting the thickness of the water absorption layer 120 to be less than or equal to 5 mm, the probability of condensed water generation can be reduced to the greatest extent.

Optionally, H may be equal to 2 mm, 3 mm, 4 mm, or 5 mm.

Referring to FIG. 2 to FIG. 5 again, the embodiments of the present application provide the main control box 120 including the box body 130 accommodating the control component 160 of a battery; and the box cover 140 disposed above the box body 130 and covering the box body 130, wherein a lower surface of the box cover 140 is sprayed with the water absorption layer 150. The material of the water absorption layer 150 is a polyurethane waterproof coating, and the water absorption layer is used to absorb water vapor within the main control box 120. The control component 160 includes the battery management unit 161, and the orthographic projection of the water absorption layer 150 on the box cover 140 covers the orthographic projection of the battery management unit 161 on the box cover 140. The drainage plate 171 is disposed below the water absorption layer 150 and covers at least a part of the water absorption layer 150, the opening 180 is formed between the first end 1711 of the drainage plate 171 in the first direction X and the box cover 140, the second end 1712 of the drainage plate 171 in the first direction X is fixedly connected to the box cover 140, the orthographic projection of the first end 1711 on the box cover 140 is staggered with the orthographic projection of the battery management unit 161 on the box cover 140, the orthographic projection of the second end 1712 on the box cover 140 is staggered with the orthographic projection of the battery management unit 161 on the box cover 140, the first direction X is perpendicular to the gravity direction G of the main control box 120, the box body 130 includes the first side wall 131, the first side wall 131 is the wall of the box body 130 closer to the opening 180 in the first direction X, and the gap L is provided between the opening 180 and the first side wall 131; and the drainage groove 172 is provided within the gap L, and the drainage groove 172 is in communication with the opening 180. The thickness H of the water absorption layer 150 satisfies 2 mm ≤ H ≤ 5 mm.

In this embodiment, the polyurethane waterproof coating is used as the water absorption layer 150, and the polyurethane material has a low thermal conductivity coefficient since it has a stable porosity structure, predominantly a closed-pore structure. When the polyurethane material is sprayed on the box cover 140, heat conduction is slower when an external temperature is relatively low and an internal temperature is relatively high, the internal temperature decreases slowly, and condensation is not easily formed. When very little condensation occurs internally, the polyurethane material can also react with water to absorb it, thereby effectively reducing the probability of condensed water generation. In addition, by disposing the drainage plate 171 and the drainage groove 172 within the main control box 120, condensed water does not drop onto the battery management unit 161 even if the condensed water is generated above the battery management unit 161, thereby enabling further improvement in the performance stability of the main control box 120. By setting the thickness H of the water absorption layer 150 to be greater than or equal to 2 mm and less than or equal to 5 mm, the probability of condensed water generation may be reduced to the greatest extent.

A main control box 1# with a lower surface of a box cover sprayed with polyurethane and a main control box 2# with a lower surface of a box cover not provided with a water absorption layer are tested. Specifically, the main control box 1# and the main control box 2# are subjected to charging and discharging at full power of 0.5 P at a normal temperature of 25°C and a high temperature of 55°C, and it may be obviously seen that the overall temperature of the main control box 1# is higher than that of the main control box 2# by 2~3°C. That is, under normal-temperature and high-temperature operation conditions, the internal and ambient temperatures of the main control box 1# sprayed with polyurethane satisfy normal requirements, that is, the performance of the main control box 1# is not affected.

A main control box 3# with a lower surface of a box cover sprayed with polyurethane, a main control box 4# with a lower surface of a box cover coated with a flocking material, and a main control box 5# with a lower surface of a box cover not provided with a water absorption layer are tested. Specifically, in a stage constructing a test bench: 1. the three main control boxes to be tested are numbered as 3#, 4#, and 5#, and the box covers of the three main control boxes are processed according to the above manners; 2. after the processing of the main control boxes is completed, pictures are taken for recording, and then upper covers are locked according to corresponding torsion forces; 3. external high and low pressures are connected to make the test environment for the main control boxes consistent with a container in practice; 4. temperature sensing wires are placed within the main control boxes to detect their internal environment temperatures, and 5. the three main control boxes are connected in series to a DC source. In a pretest check stage: 1. an insulation resistance (1000 VDC, 60s, with both rise time and fall time of 10 s, R ≥ 20 MΩ) is detected; and 2. a voltage-endurance leakage current (4200 VDC, 60s, with both rise time and fall time of 10s, I ≤ 1 mA) is detected. In a test stage (the main control boxes 3#, 4#, and 5# with box covers closed-charging and discharging testing), 1. a climate chamber is activated, and after the actual temperature and humidity of the climate chamber reach 55±2°C and 95±2% RH, standing is made for 1 h; 2. an overcurrent of 140 A is applied for 4 h; 3. standing is made for 4 h; 4. an overcurrent of 140 A is applied for 4 h; 5. standing is made for 4 h; and 6. 2~5 cycles are made, with testing for 5 d in total, and one dielectric withstand test is performed once every 24 h with the climate chamber opened. Three sets of tests are performed repeatedly, followed by a post-test check.

By comparing the main control boxes 3#, 4#, and 5#, it is found that the main control box 3# sprayed with polyurethane has the least amount of condensed water, the main control box 4# coated with a flocking material has the second least amount of condensed water, and the main control box 5# with a box cover having no treatment applied has the largest amount of condensed water.

An embodiment of the present application also provides an energy storage system including a battery and the main control box 120 according to the above embodiments.

An embodiment of the present application also provides an electric device including a battery and the main control box 120 according to the above embodiments.

The electric device may be a vehicle, or may be any apparatus using a battery.

Although the present application has been described with reference to some preferred embodiments, various modifications to this application and replacements of the components therein with equivalents can be made without departing from the scope of the present application. In particular, the technical features mentioned in the embodiments may be combined in any manner provided that no structural conflict is present. The present application is not limited to the specific embodiments disclosed herein, but includes all technical solutions falling within the scope of the claims.

## Claims

1. A main control box, comprising:
a box body accommodating a control component of a battery; and
a box cover disposed above the box body and covering the box body;
wherein a lower surface of the box cover is provided with a water absorption layer for absorbing water vapor within the main control box; and
the control component comprises a battery management unit, and the orthographic projection of the water absorption layer on the box cover covers the orthographic projection of the battery management unit on the box cover.

2. The main control box according to claim 1, wherein the main control box further comprises a drainage structure for draining condensed water generated above the battery management unit out of the battery management unit.

3. The main control box according to claim 2, wherein the drainage structure comprises a drainage plate disposed below the water absorption layer and covering at least a part of the water absorption layer; and
an opening is formed between a first end of the drainage plate in a first direction and the box cover, and a second end of the drainage plate in the first direction is fixedly connected to the box cover;
wherein the orthographic projection of the first end on the box cover is staggered with the orthographic projection of the battery management unit on the box cover, and the first direction is perpendicular to a gravity direction of the main control box.

4. The main control box according to claim 3, wherein the orthographic projection of the second end on the box cover is staggered with the orthographic projection of the battery management unit on the box cover.

5. The main control box according to claim 3 or 4, wherein the box body comprises a first side wall, the first side wall is a wall of the box body closer to the opening in the first direction, and a gap is provided between the opening and the first side wall; and
the drainage structure further comprises a drainage groove disposed within the gap and communicating with the opening.

6. The main control box according to any one of claims 1 to 5, wherein the material of the water absorption layer comprises a polyurethane waterproof coating.

7. The main control box according to any one of claims 1 to 5, wherein the material of the water absorption layer comprises a flocking material.

8. The main control box according to any one of claims 1 to 7, wherein the thickness of the water absorption layer is greater than or equal to 2 mm.

9. The main control box according to any one of claims 1 to 8, wherein the thickness of the water absorption layer is smaller than or equal to 5 mm.

10. An energy storage system, comprising a battery and the main control box according to any one of claims 1 to 9.

11. An electric device, comprising a battery and the main control box according to any one of claims 1 to 9.
